# EUROPÄISCHE PATENTSCHRIFT

(11) **EP 2 791 690 B1**
(45) Veröffentlichungstag und Bekanntmachung des Hinweises auf die Patenterteilung: **03.07.2019**
(21) Anmeldenummer: 12791728.4
(22) Anmeldetag: 14.11.2012
(51) Int. Cl.: G01R 19/00, G01R 35/00

(54) **VERFAHREN ZUR ÜBERPRÜFUNG EINER ELEKTRISCHEN STROMMESSUNG, SCHALTUNG ZUR DURCHFÜHRUNG DES VERFAHRENS, BATTERIE UND KRAFTFAHRZEUG**
METHOD FOR CHECKING AN ELECTRICAL CURRENT MEASUREMENT, CIRCUIT FOR CARRYING OUT THE METHOD, BATTERY AND MOTOR VEHICLE
PROCÉDÉ DE CONTRÔLE DE LA MESURE D'UN COURANT ÉLECTRIQUE, CIRCUIT PERMETTANT LA MISE EN OEUVRE DUDIT PROCÉDÉ, BATTERIE ET VÉHICULE À MOTEUR

(30) Priorität: 14.12.2011 DE 102011088590
(43) Veröffentlichungstag der Anmeldung: 22.10.2014
(73) Patentinhaber: Robert Bosch GmbH, 70442 Stuttgart (DE); Samsung SDI Co., Ltd., Yongin-si Gyeonggi-do 446-577 (KR)
(72) Erfinder: KAUPP, Patrick, 70195 Stuttgart (DE)
(74) Vertreter: Bee, Joachim
(86) Internationale Anmeldenummer: PCT/EP2012/072535
(87) Internationale Veröffentlichungsnummer: WO 2013/087327

(56) Entgegenhaltungen:
- DE-A1- 4 230 939
- DE-A1-102006 011 178
- US-A- 5 721 688
- US-A1- 2004 145 373

## Beschreibung

Die vorliegende Erfindung betrifft ein Verfahren zur Überprüfung einer elektrischen Strommessung und eine Schaltung, mit der das Verfahren zur Überprüfung einer elektrischen Strommessung durchgeführt werden kann.

Ferner betrifft die Erfindung eine Batterie mit der erfindungsgemäßen Schaltung sowie ein Kraftfahrzeug mit der erfindungsgemäßen Batterie.

### Stand der Technik

Es zeichnet sich ab, dass in Zukunft sowohl bei stationären Anwendungen, wie Windkraftanlagen, in Kraftfahrzeugen, die als Hybrid- oder Elektrokraftfahrzeuge ausgelegt sind, als auch bei Elektronikgeräten, wie Laptops oder Mobiltelefonen, neue Batteriesysteme zum Einsatz kommen werden, an die sehr hohe Anforderungen bezüglich Zuverlässigkeit, Sicherheit, Leistungsfähigkeit und Lebensdauer gestellt werden.

In Fahrzeugen mit zumindest teilweisem elektrischen Antrieb kommen elektrische Energiespeicher zum Einsatz, um die elektrische Energie für den Elektromotor, welcher den Antrieb unterstützt bzw. als Antrieb dient, zu speichern. In den Fahrzeugen der neuesten Generation finden hierbei sogenannte Lithium-Ionen-Batterien Verwendung. Diese zeichnen sich unter anderem durch hohe Energiedichten und eine äußerst geringe Selbstentladung aus. Lithium-Ionen-Zellen besitzen mindestens eine positive und eine negative Elektrode (Kathode bzw. Anode), die Lithium-Ionen (Li+) reversibel ein-(Interkalation) oder wieder auslagern (Deinterkalation) können.

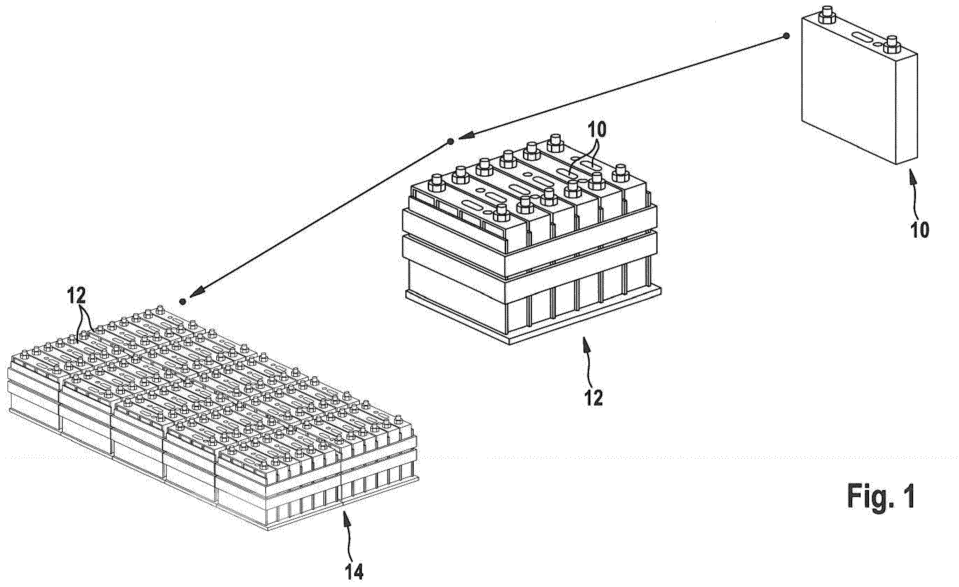

Figur 1 zeigt, wie einzelne Batteriezellen 10 zu Batteriemodulen 12 und dann zu Batterien 14 zusammengefasst werden können. Dies erfolgt durch eine nicht dargestellte Parallel- oder Reihenschaltung der Pole der Batteriezellen 10. Dabei besteht per Definition ein Batteriemodul 12 bzw. eine Batterie 14 aus mindestens zwei Batteriezellen 10, wobei die Begriffe Batterie 14 und Batteriemodul 12 oft synonym verwendet werden. Die elektrische Spannung einer Batterie 14 beträgt beispielsweise zwischen 120 und 600 Volt Gleichstrom.

Bei Batterien für automobile Antriebstechniken (Traktionsbatterien) besteht die Notwendigkeit, zur Bestimmung des Ladezustands und aus Sicherheitsgründen, den zu- und abgeführten Strom der Batteriezellen zu messen. Deshalb muss die Funktionsfähigkeit des Stromsensors bekannt und daher durch geeignete Maßnahmen detektierbar sein. In vielen Fällen erfolgt die Erfassung des Stroms mit Hilfe von Stromsensoren, die nach dem Widerstandsprinzip arbeiten (Shunt). Eine weitere Möglichkeit zur Erfassung eines elektrischen Stroms besteht darin, Sensoren einzusetzen, welche das durch den Stromfluss in einem Leiter hervorgerufene Magnetfeld um den Leiter erfassen und daraus auf den Stromfluss rückschließen. Um eine redundante Messung zu ermöglichen, können auch beide Messprinzipien gleichzeitig eingesetzt werden, wodurch der Strom mittels zweier unterschiedlicher Messprinzipien gemessen wird.

Die DE102006011178 A1 offenbart ein Verfahren zum Überprüfen eines elektrischen Stromwandlers, wobei der Stromwandler zur Wandlung eines unbekannten elektrischen Primärstroms in einem Primärleiter in eine mit dem Primärstrom korrelierte Messgrösse an einem Messausgang des Stromwandlers dient.

Die DE 10 2009 046 564 A1 offenbart ein Batteriesystem mit einem Hochspannungsnetz und einem Niederspannungsnetz. Das Hochspannungsnetz umfasst ein Batteriemodul, während das Niederspannungsnetz eine Battery Control Unit (BCU) umfasst. Zellüberwachungseinheiten sind den Batteriezellen zugeordnet und messen die Spannungen der Batteriezellen. Des Weiteren offenbart die Druckschrift eine redundante Strommessung mittels eines Messwiderstandes (Shunt) und eines Hall-Sensors.

### Offenbarung der Erfindung

Erfindungsgemäß wird ein Verfahren zur Überprüfung einer elektrischen Strommessung zur Verfügung gestellt. In einem ersten Schritt wird ein zu messender elektrischer Stroms I_{M} mit einem Mittel zum Strommessen gemessen. In einem zweiten Schritt wird der zu messende elektrische Stroms I_{M} mit einem Prüfstrom I_{P} zu einem resultierenden Strom I_{Res}=I_{M}+I_{P} überlagert. In einem dritten Schritt, welcher innerhalb der Zeitspanne vom zweiten Schritt erfolgt, wird der resultierende Strom I_{Res} mit dem Mittel zum Strommessen gemessen. In einem vierten Schritt wird überprüft, ob der im dritten Schritt gemessene resultierende Strom I_{Res} der Summe aus dem im ersten Schritt gemessenem Strom I_{M} plus der bekannten Größe des im zweiten Schritt überlagerten Prüfstroms I_{P} entspricht.

Damit die im vierten Schritt vollzogene Überprüfung brauchbare Ergebnisse liefert, sollte sichergestellt sein, dass der im ersten Schritt gemessene zu messende elektrische Strom I_{M} gleich groß ist wie der zu messende Strom I_{M} im zweiten Schritt. Dies ist beispielsweise dann der Fall, wenn weitere Informationen über den zu messenden Strom I_{M} vorliegen, beispielsweise ob der zu messende Strom I_{M} konstant ist oder kein zu messender Strom I_{M} (I_{M} = 0) fließt. Bei einer Anwendung des erfindungsgemäßen Verfahrens in einem Kraftfahrzeug ist der zu messende Strom I_{M} beispielsweise konstant, wenn sich das Kraftfahrzeug in einem stationären Zustand befindet, wohingegen kein zu messender Strom I_{M} (I_{M} = 0) fließt, bevor ein System, dessen zu messender Strom I_{M} gemessen wird, in den Ruhezustand übergeht oder beim Starten des Systems.

Der Erfindung liegt die Erkenntnis zu Grunde, eine elektrische Stommessung und somit ein Mittel zum Strommessen überprüfen zu können, indem einem durch eine erste Messung bekannten Strom (zu messender Strom I_{M}) ein Strom bekannter Größe (Prüfstrom I_{P}) überlagert wird. Durch die Überlagerung der beiden Ströme addieren sich diese zu einem resultierenden Strom I_{Res}=I_{M}+I_{P}, welcher in einer zweiten Messung ebenfalls gemessen wird. Anschließend wird überprüft, ob der in der zweiten Messung gemessene resultierende Strom I_{Res} der Summe aus dem in der ersten Messung gemessenen zu messenden Strom I_{M} plus dem überlagerten Prüfstrom I_{P} entspricht. Wenn dies der Fall ist, ist sichergestellt, dass das Mittel zum Strommessen Differenzen eines Stromflusses durch einen Leiter korrekt messen. Diese Reaktion kann als Indiz für das korrekte Funktionieren der Einheit herangezogen werden, es kann somit davon ausgegangen werden, dass auch der Absolutwert der Messung korrekt ist.

Zur Überprüfung der Mittel zum Strommessen bedarf es somit keiner redundanten Auslegung mit Hilfe eines zweiten Stromsensors, wodurch Kosten gespart werden können.

Im normalen Betrieb des Mittels zum Strommessen wird der zu messende Strom I_{M} entsprechend dem ersten Schritt gemessen, ohne dass diesem ein Prüfstrom I_{P} überlagert ist. Soll nun gemäß dem zweiten und dritten Schritt der zu messende Strom I_{M} mit dem Prüfstrom I_{P} bekannter Größe überlagert werden, so dient dafür beispielsweise eine Stromquelle, welche während des zweiten und somit auch dritten Schrittes eingeschaltet ist, während sie im ersten Schritt ausgeschaltet ist.

Mittels eines Schrittes des Bereitstellens eines Schaltmittels, über welches der Prüfstrom I_{P} im zweiten und dritten Schritt geführt wird, kann das Mittel zum Stromeinspeisen auf einfache Art und Weise den Prüfstrom I_{P} dem zu messenden Strom I_{M} überlagern. Mittels eines weiteren Schrittes des Erkennens des Schaltzustandes des Schaltmittels kann dann auf das Fließen des Prüfstroms I_{P} geschlossen werden. Ist das Schaltmittel offen, fließt kein Prüfstrom I_{P}, ist es geschlossen, fließt ein Prüfstrom I_{P}. So kann das Erkennen eines geschlossenen Schaltmittels vorzugsweise als Trigger für eine Überprüfung gemäß dem vierten Schritt genutzt werden.

Ferner wird eine elektrische Schaltung zur Durchführung des erfindungsgemäßen Verfahrens zur Überprüfung einer elektrischen Strommessung zur Verfügung gestellt. Die elektrische Schaltung umfasst ein Mittel zum Strommessen und eine Stromquelle, wobei die Stromquelle dazu ausgebildet ist, dem zu messenden Strom I_{M} einen Prüfstrom I_{P} bekannter Größe bei Bedarf zu überlagern. Dies geschieht derart, dass das Mittel zum Strommessen einen resultierenden Strom I_{Res}=I_{M}+I_{P} messen kann.

Die Stromquelle kann bei Bedarf aktiviert werden, wodurch ein praktisch konstanter Prüfstrom I_{P} zur Verfügung gestellt und dem zu messenden Strom I_{M} überlagert wird. Dieser ist ferner bevorzugt einstellbar, wodurch der Prüfstrom I_{P} auf die jeweiligen Erfordernisse, beispielsweise in Abhängigkeit des zu messenden Stroms I_{M}, eingestellt werden kann. Die wenigen zusätzlich zum Mittel zur Strommessung benötigten Bauteile können leicht in ein bestehendes Messmodul integriert werden.

Ein Schaltmittel ist zwischen der Stromquelle und dem Mittel zum Strommessen geschaltet, welches ferner bevorzugt ein Transistor ist. In diesem Fall kann die Stromquelle dauerhaft aktiviert bleiben, durch Schalten des Schaltmittels, beispielsweise durch eine Kontrolleinheit, kann der Prüfstrom I_{P} bei Bedarf dem zu messenden Strom I_{M} überlagert werden. Aus dem Schaltzustand des Schaltmittels kann dann geschlossen werden, ob der Prüfstrom I_{P} fließt oder nicht.

Die zuschaltbare Stromquelle kann bevorzugt durch eine Reihenschaltung einer Spannungsquelle, eines Widerstandes und des Schaltmittels realisiert sein. Durch diese Ausgestaltung kann eine einfach ausgeführte Stromquelle realisiert sein.

Nach einer bevorzugten Ausgestaltung der Erfindung ist das Strommessmittel ein Messwiderstand mit einer Auswerteschaltung. Die Auswerteschaltung misst den Spannungsabfall am Messwiderstand, welcher ein Maß für den durch den Messwiderstand fließenden Strom darstellt. Um am Messwiderstand keine großen Verlustleistungen zu erzeugen, wird dieser in der Regel sehr klein dimensioniert, so dass am Messwiderstand nur kleine Spannungsabfälle entstehen, welche von der Auswerteschaltung verstärkt werden.

Des Weiteren wird eine Batterie umfassend die erfindungsgemäße elektrische Schaltung zur Verfügung gestellt. Durch den einfachen und kostengünstigen Aufbau der erfindungsgemäßen elektrischen Schaltung können die Kosten der Batterie im Vergleich zum Stand der Technik gesenkt werden.

Vorzugsweise ist die Batterie eine Lithium-Ionen-Batterie, welche eine Mehrzahl an Lithium-Ionen-Sekundärzellen umfasst. Durch die Verwendung der Lithium-Ionen-Technologie können besonders hohe Energiespeicherdichten erzielt werden, was besonders im Bereich der Elektromobilität zu weiteren Vorteilen führt.

Ferner wird ein Kraftfahrzeug zur Verfügung gestellt, welches die erfindungsgemäße Batterie umfasst. Die Batterie ist in der Regel zur Speisung eines elektrischen Antriebssystems des Fahrzeuges vorgesehen.

Vorteilhafte Weiterbildungen der Erfindung sind in den Unteransprüchen angegeben und können der Beschreibung entnommen werden.

### Zeichnungen

Ausführungsbeispiele der Erfindung werden anhand der Zeichnungen und der nachfolgenden Beschreibung näher erläutert. Es zeigen:
Figur 1 Batteriezelle, Batteriemodul und Batterie (Stand der Technik),
Figur 2 eine erfindungsgemäße Schaltung, wobei dem zu messenden Strom I_{M} kein Prüfstrom I_{P} überlagert wird, und
Figur 3 die erfindungsgemäße Schaltung, wobei dem zu messenden Strom I_{M} ein Prüfstrom I_{P} überlagert wird.

Auf Figur 1 wurde bereits zur Erläuterung des Standes der Technik eingegangen.

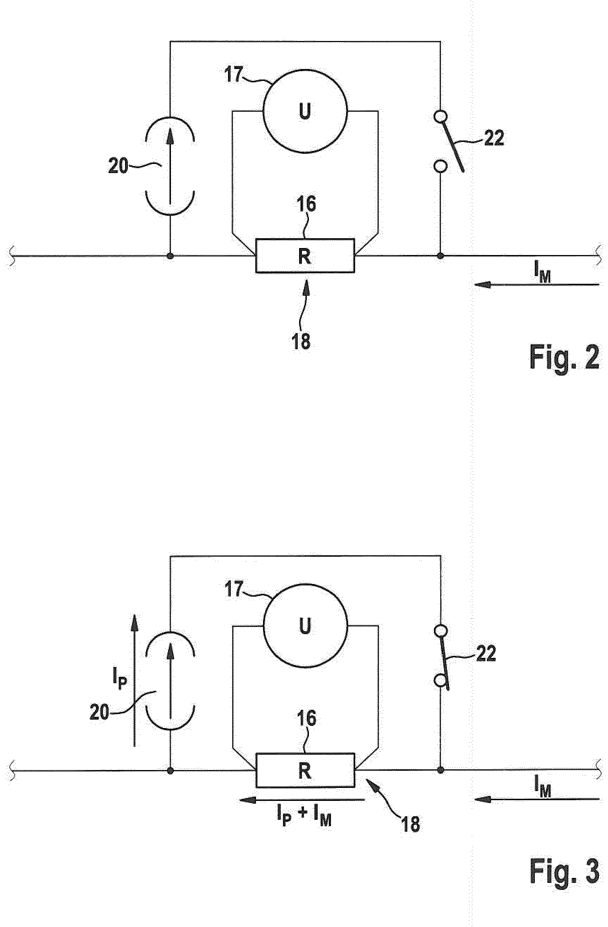

Figur 2 zeigt eine erfindungsgemäße Schaltung, wobei ein, in einem elektrischen Leiter fließender zu messender Strom I_{M} von einem Mittel zum Strommessen 18 erfasst wird. Das Mittel zum Strommessen 18 kann wie üblich durch einen Messwiderstand 16 und eine Auswerteschaltung 17 realisiert sein. Eine Stromquelle 20 ist über ein Schaltmittel 22 mit dem, vom zu messenden Strom I_{M} durchflossenen, elektrischen Leiter vor und nach dem Mittel zum Strommessen 18 elektrisch leitend verbunden.

Im normalen Messbetrieb ist das Schaltmittel 22 geöffnet, es fließt kein Prüfstrom I_{P}. Das Mittel zum Strommessen 18 misst somit lediglich den zu messenden Strom I_{M}. Dies dient auch als erster Schritt des erfindungsgemäßen Verfahrens. Dies erfolgt gemäß Figur 2 durch den Messwiderstand 16 in Kombination mit der Auswerteschaltung 17. Die Auswerteschaltung 17 ist in der Lage, auch einen kleinen Spannungsabfall, welcher als Maß für den Stromfluss durch den Messwiderstand 16 dient, zu verstärken und auszuwerten.

Der zweite und dritte Schritt des erfindungsgemäßen Verfahrens wird mit einer Schalterstellung des Schaltmittels 22 gemäß Figur 3 durchgeführt. Das Schaltmittel 22 ist geschlossen, es fließt ein Prüfstrom I_{P} bekannter Größe über das Schaltmittel 22 und somit durch den Messwiderstand 16.

Durch den Messwiderstand 16 in Kombination mit der Auswerteschaltung 17 wird ein resultierender Strom I_{Res} gemessen, welcher der Summe aus dem zu messenden Strom I_{M} und dem Prüfstrom I_{P} entspricht. Unter der Voraussetzung, dass der zu messende Strom I_{M} bei geschlossenem Schaltmittel 22 dieselbe Höhe hat wie der gemessene zu messende Strom I_{M} bei geöffnetem Schaltmittel 22, kann nun die Strommessung überprüft werden. Dies geschieht durch einen Vergleich der gemessenen Ströme bei offenem und geschlossenem Schaltmittel 22. So muss der bei geschlossenem Schaltmittel 22 gemessene resultierende Strom I_{Res} der Summe aus dem mit offenem Schaltmittel 22 gemessenen zu messenden Strom I_{M} und dem Prüfstrom I_{P} bekannter Größe entsprechen. Sollte dies nicht der Fall sein, kann von einer Fehlfunktion des Mittels zur Strommessung 18 ausgegangen werden. Es gilt jedoch zu beachten, dass eine solche Abweichung auch zu Stande kommt, wenn der zu messende Strom I_{M} bei geöffnetem Schaltmittel 22 nicht dem zu messende Strom I_{M} bei geschlossenem Schaltmittel 22 entspricht.

## Patentansprüche

1. Verfahren zur Überprüfung einer elektrischen Strommessung umfassend die folgenden Schritte:
(I) Messen eines zu messenden Stroms I_{M} mit einem Mittel zum Strommessen (18),
(II) Überlagern des zu messenden Stroms I_{M} mit einem Prüfstrom I_{P} zu einem resultierenden Strom I_{Res}=I_{M}+I_{P},
(III) Messen des resultierenden Stroms I_{Res} mit dem Mittel zum Strommessen (18) innerhalb der Zeitspanne von Schritt (II),
(IV) Überprüfen, ob der in Schritt (III) gemessene resultierende Strom I_{Res} der Summe aus dem in Schritt (I) gemessenem Strom I_{M} plus der bekannten Größe des in Schritt (II) überlagerten Prüfstroms I_{P} entspricht,
(V) Erkennen eines Schaltzustandes eines Schaltmittels (22), über welches der Prüfstrom I_{P} in Schritt (II) und (III) geführt wird, woraus auf das Fließen des Prüfstroms I_{P} geschlossen werden kann.

2. Elektrische Schaltung zur Durchführung des Verfahrens zur Überprüfung einer elektrischen Strommessung nach Anspruch 1, umfassend ein Mittel zum Strommessen (18) und eine Stromquelle (20), wobei die Stromquelle (20) dazu ausgebildet ist, einen Prüfstrom I_{P} bekannter Größe dem zu messenden Strom I_{M} bei Bedarf zu überlagern, derart, dass das Mittel zum Strommessen (18) einen resultierenden Strom I_{Res}=I_{M}+I_{P} messen kann, wobei ein Schaltmittel (22) zwischen der Stromquelle (20) und dem Mittel zum Strommessen (18) geschaltet ist.

3. Elektrische Schaltung nach Anspruch 2, wobei das Schaltmittel (22) ein Transistor ist.

4. Elektrische Schaltung nach einem der Ansprüche 2 oder 3, wobei das Strommessmittel ein Messwiderstand mit einer Auswerteschaltung ist.

5. Batterie (14) umfassend die elektrische Schaltung nach einem der Ansprüche 2 bis 4.

6. Kraftfahrzeug umfassend die Batterie (14) nach Anspruch 5.

## Claims

1. Method for checking an electrical current measurement comprising the following steps:
(I) measuring a current I_{M} to be measured using a means (18) for measuring the current,
(II) superposing a test current I_{P} on the current I_{M} to be measured to give a resultant current I_{Res}=I_{M}+I_{P},
(III) measuring the resultant current I_{Res} using the means (18) for measuring the current within the time span of step (II),
(IV) checking whether the resultant current I_{Res} measured in step (III) corresponds to the sum of the current I_{M} measured in step (I) and the known magnitude of the test current I_{P} superposed in step (II),
(V) detecting a switching state of a switching means (22) via which the test current I_{P} is conducted in step (II) and (III), from which a conclusion can be drawn in respect of the flow of the test current I_{P}.

2. Electrical circuit for carrying out the method for checking an electrical current measurement according to Claim 1, comprising a means (18) for measuring the current and a current source (20), wherein the current source (20) is designed to superpose, as required, a test current I_{P} of known magnitude on the current I_{M} to be measured such that the means (18) for measuring the current can measure a resultant current I_{Res}=I_{M}+I_{P}, wherein a switching means (22) is connected between the current source (20) and the means (18) for measuring the current.

3. Electrical circuit according to Claim 2, wherein the switching means (22) is a transistor.

4. Electrical circuit according to either of Claims 2 and 3, wherein the current-measuring means is a measuring resistor with an evaluation circuit.

5. Battery (14) comprising the electrical circuit according to one of Claims 2 to 4.

6. Motor vehicle comprising the battery (14) according to Claim 5.

## Revendications

1. Procédé, destiné à vérifier une mesure de courant électrique, comportant les étapes suivantes consistant à :
(I) mesurer un courant I_{M} qui doit être mesuré à l'aide d'un moyen destiné à mesurer le courant (18),
(II) superposer au courant I_{M} qui doit être mesuré un courant de test I_{P} pour obtenir un courant résultant I_{Res}=I_{M}+I_{P},
(III) mesurer le courant résultant I_{Res} à l'aide du moyen destiné à mesurer le courant (18) au sein d'une période de l'étape (II),
(IV) vérifier si le courant résultant I_{Res} mesuré dans l'étape (III) correspond à la somme du courant I_{M} mesuré à l'étape (I), plus la grandeur connue du courant de test I_{P} superposé dans l'étape (II),
(V) identifier un état de commutation d'un moyen de commutation (22), par l'intermédiaire duquel le courant de test Ip est conduit dans l'étape (II) et (III), suite à quoi, on peut déduire si le courant de test I_{P} circule.

2. Circuit électrique, destiné à réaliser le procédé destiné à vérifier une mesure de courant électrique, selon la revendication 1, comprenant un moyen destiné à mesurer le courant (18) et une source de courant (20), la source de courant (20) étant conçue pour superposer en cas de besoin au courant I_{M} qui doit être mesuré un courant de test I_{P} de grandeur connue, de telle sorte que le moyen destiné à mesurer le courant (18) puisse mesurer un courant résultant I_{Res}=I_{M}+I_{P}, un moyen de commutation (22) étant connecté entre la source de courant (20) et le moyen destiné à mesurer le courant (18).

3. Circuit électrique selon la revendication 2, le moyen de commutation (22) étant un transistor.

4. Circuit électrique selon l'une quelconque des revendications 2 ou 3, le moyen destiné à mesurer le courant étant une résistance de mesure, pourvue d'un circuit d'évaluation.

5. Batterie (14), comprenant le circuit électrique selon l'une quelconque des revendications 2 à 4.

6. Véhicule automobile, comprenant la batterie (14) selon la revendication 5.
